Europäisches Patentamt

European Patent Office

Office européen des brevets

(11) Publication number: **0 034 465**
**B1**

## EUROPEAN PATENT SPECIFICATION

(45) Date of publication of patent specification: **21.11.85**

(21) Application number: **81300566.7**

(22) Date of filing: **12.02.81**

(51) Int. Cl.⁴: **G 11 C 11/24, G 11 C 11/40**

(54) Address buffer circuit.

(30) Priority: **16.02.80 JP 18018/80**

(43) Date of publication of application:
**26.08.81 Bulletin 81/34**

(45) Publication of the grant of the patent:
**21.11.85 Bulletin 85/47**

(84) Designated Contracting States:
**DE FR GB NL**

(56) References cited:
**DE-A-2 818 350**

**IEEE INTERNATIONAL SOLID-STATE CIRCUITS
CONFERENCE, 15th February 1979, pages 148-
149, New York, USAD.V.ESSL et al.: " THPM
12.5: A 64Kb VMOS RAM ".**

(73) Proprietor: **FUJITSU LIMITED
1015, Kamikodanaka Nakahara-ku
Kawasaki-shi Kanagawa 211 (JP)**

(72) Inventor: **Shimada, Hiroshi
33-3, Kitashinjuku 4-chome Shinjuku-ku
Tokyo 160 (JP)**

(74) Representative: **Sunderland, James Harry et al
HASELTINE LAKE & CO Hazlitt House 28
Southampton Buildings Chancery Lane
London WC2A 1AT (GB)**

Courier Press, Leamington Spa, England.

**Description**

This invention relates to an address buffer circuit.

For example, in a RAM (Random Access Memory) in which memory cells are arranged in the form of a matrix a memory cell is in general selected in accordance with outputs of row and column address decoders. These address decoders are generally composed of NOR gates and to these NOR gates there are supplied specified signals from amongst in-phase internal address signals and inverse-phase internal address signals which internal address signals are generated, in address buffer circuits, from an external address input.

Recently, with a view to reducing power consumption, address buffer circuits are often designed so that power consumption by such address buffer circuits is suspended during stand-by periods in response to a signal generated from an external chip select input signal. In such a power-down type address buffer circuit, output timing depends upon the relationship between an external chip select input signal and an external address input signal, and output timing differs when the external chip select input signal and the external address input signal bear different relationships. Differences in output timing are generally very short periods which do not cause any problems when chip select access is faster than address access, but when chip select access is slower than address access because of the circuit design, the differences can give rise to a slower access time for a memory.

DE—A1—28 18 350 discloses an address buffer circuit employing an address flip-flop with control switching circuitry. Output points of the flip-flop are short circuited by a transistor M8 when the buffer circuit is in-active.

According to the present invention there is provided an address buffer circuit operable to receive an externally provided address input, said circuit comprises a first push-pull output circuit having a first depletion MOS transistor and a first enhancement MOS transistor connected to the first depletion MOS transistor, respective gates of which first transistors are arranged for receiving respective address input signals which are mutually complementary, and

a second push-pull output circuit having a second depletion MOS transistor and a second enhancement MOS transistor connected to the second depletion MOS transistor, respective gates of which second transistors are arranged for receiving respective said address input signals,

said first and second push-pull output circuits being operable in an active period to provide, at respective output terminals thereof, a pair of mutually complementary output signals of levels dependent upon the address input signals; and further comprises

power down MOS transistors operable in a stand-by period, designated by a signal provided externally of the buffer circuit, to pull down the gate levels of the first and second depletion and enhancement MOS transistors in order to reduce power consumption by the buffer circuit,

characterised in that a short circuit means is connected between the respective output terminals, which means is operable to set the potentials of the output terminals in a standby period to a level between high and low levels of the output terminals in an active period, by electrically connecting the output terminals.

An embodiment of the present invention can provide an address buffer circuit which does not suffer the disadvantage mentioned above and which assures high speed operation.

An embodiment of this invention can provide an address buffer circuit of a simple structure.

Reference is made, by way of example, to the accompanying drawings, in which:—

Figure 1 is a schematic circuit diagram illustrating an address buffer circuit embodying the present invention;

Figure 2 is a schematic circuit diagram illustrating a circuit for generating an internal chip select signal;

Figures 3A to 3E are respective waveform diagrams illustrating signals which arise at respective circuit points in a conventional address buffer circuit;

Figures 4A to 4D are respective waveform diagrams illustrating signals which arise at respective circuit points in an address buffer circuit embodying the present invention.

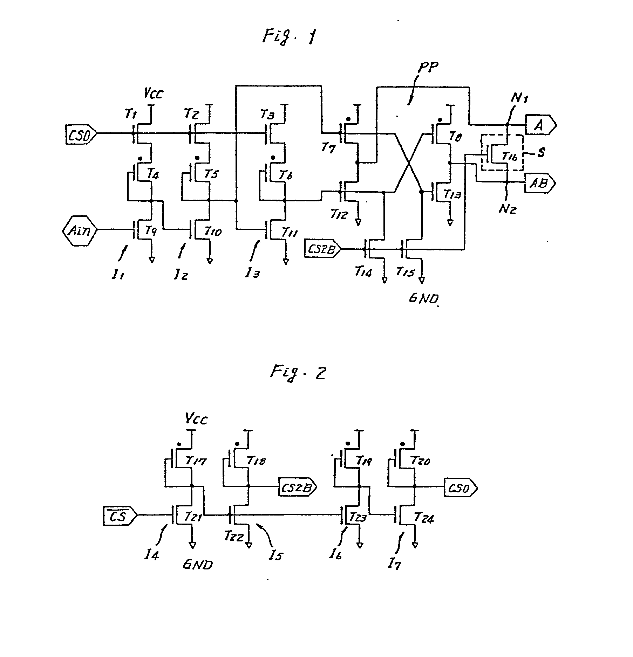

Figure 1 illustrates a power-down type address buffer circuit embodying the present invention.

If short circuit means S and connections thereto were absent, the buffer circuit of Figure 1 would correspond to a conventional buffer circuit.

In Figure 1, depletion type MOS transistors $T_4$ to $T_6$ and enhancement type MOS transistors $T_9$ to $T_{11}$ form three invertor stages $I_1$ to $I_3$, whilst depletion type MOS transistors $T_7$, $T_8$ and enhancement type MOS transistors $T_{12}$, $T_{13}$ form a push-pull output circuit stage PP. The three invertor stages $I_1$ to $I_3$ effect successive inversions of an internal address input $A_{in}$. An output of second invertor stage $I_2$ is applied to the respective gates of transistor $T_7$, $T_{13}$ of the push-pull output circuit stage PP, whilst an output of the third invertor stage $I_3$ is applied to the gates of transistors $T_{12}$, $T_8$ of circuit PP.

The transistors $T_7$ and $T_{12}$ form a first push-pull output circuit, and the transistors $T_8$ and $T_{13}$ form a second push-pull ouput circuit of the stage PP. The gates of the two transistors of each push-pull output circuit receive address input signals which are mutually complementary. Thereby, an internal address signal A which is in-phase with the external address input $A_{in}$ and an internal address signal AB which has a phase the inverse of that of the signal $A_{in}$ can be obtained at complementary output terminals $N_1$, $N_2$ of the push-pull stage PP. Transistors $T_1$ to $T_3$ connected between the invertor stages $I_1$ to $I_3$ and power source $V_{cc}$ are power-down transistors. These transistors become OFF when an internal chip select signal CSO, which is inverted in phase with respect to an external chip select signal becomes "L" level during a standby period, thus disconnecting power supply from invertor stages $I_1$ to $I_3$. In addition, transistors $T_{14}$, $T_{15}$ connected between the gates of transistors of push-pull stage PP and ground potential GND are also power-down transistors. These transistors turn ON when an internal chip select signal CS2B, which is in-phase with the external chip select signal, becomes "H" level during a stand-by period, thus forcibly pulling the gates of transistors $T_7$, $T_8$, $T_{12}$ and $T_{13}$ to ground potential.

Figure 2 illustrates a circuit for generating internal chip select signals CSO and CS2B. $T_{17}$ to $T_{20}$ are depletion type load MOS transistors, while $T_{21}$ to $T_{24}$ are enhancement type drive transistors. These transistors form two invertor stages $I_4$, $I_5$ and three invertor stages $I_4$, $I_6$ and $I_7$. When an external input signal $\overline{CS}$ is applied to the first invertor stage $I_4$ the signal CS2B which is inphase with the external input is obtained from the second invertor stage $I_5$, and the signal CSO which has a phase the inverse of the external input is obtained through the invertor stages $I_4$, $I_6$ and $I_7$. This means that the internal chip select signal CSO and the signal CS2B are delayed a little from the external chip select input $\overline{CS}$ signal. Therefore, the following phenomenon would occur in the circuit of Figure 1, if the short circuit means S and connections thereto were absent.

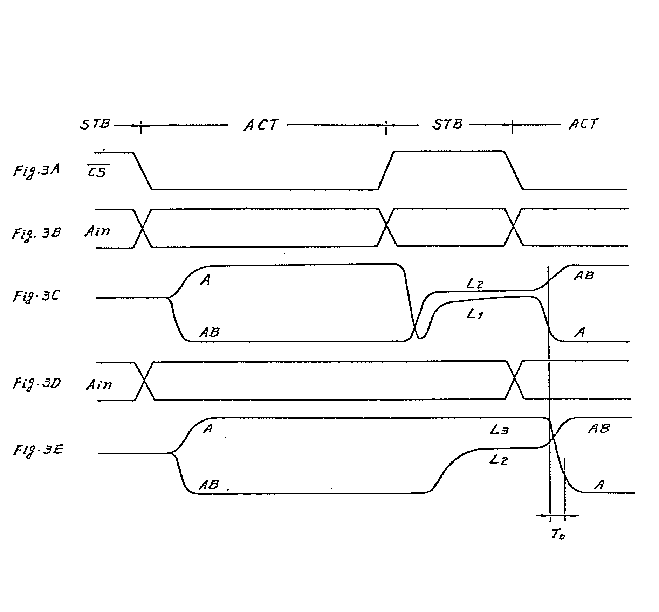

The external chip select input signal $\overline{CS}$ for the circuit shown in Figure 2 is of different levels in a stand-by period STB and an active period ACT as shown in Figure 3A.

The complementary outputs A, AB of the push-pull stage PP change in different manners as shown respectively in Figures 3C and 3E when the external address input $A_{in}$ to the circuit of Figure 1 changes in respective different manners as shown in Figures 3B and 3D.

Figure 3B illustrates a cases in which a change of external address input $A_{in}$ occurs at a timing at which the external chip select input $\overline{CS}$ enters the stand-by mode.

As explained above, since the address buffer circuit of Figure 1 is operated by internal chip select signals CSO and CS2B which are delayed a little from the external chip select input signal $\overline{CS}$, the internal signals CSO, CS2B are still at levels corresponding to an active condition (CSO in "H", while CS2B is "L") when the external signal $\overline{CS}$ has become "H", and the address buffer circuit continues operation until the internal signals CSO and CS2B achieve stand-by levels (e.g. the levels of A and AB start to change to follow up the change in $A_{in}$ in the case of Figure 3C until CSO and CS2B achieve stand-by levels). Thereafter, when the internal signal CS2B becomes "H" (stand-by) level, the gates of transistors of the push-pull stage PP are all pulled to ground potential. As a result, the enhancement type transistors $T_{12}$, $T_{13}$ are turned OFF, depletion type transistors $T_7$, $T_8$ are also turned OFF, and the outputs A, AB of the complementary output terminals $N_1$, $N_2$, in the case of the address input changing as shown in Figure 3B, take intermediate levels $L_1$, $L_2$ ($L_1 \fallingdotseq L_2$), which are determined by the threshold level of transistors $T_7$, $T_8$, as shown in Figure 3C.

If the gate and source were electrically connected, a depletion type transistor ($T_7$ or $T_8$) could provide an output of a level almost as high as power source voltage ($V_{cc}$), but when gate potential is equal to ground potential GND, as in the present case, the depletion type transistors cannot provide such a high output level but rather provide a level as indicated in Figure 3C.

Thereafter, in a following active period ACT, the internal address outputs A, AB begin changing from the immediately preceding levels $L_1$, $L_2$. In other words, the signal A falls to ground potential GND from level $L_1$, while the inverted signal AB increases to $V_{cc}$ from level $L_2$.

In contrast, when the external address input $A_{in}$ is locked, as in the case of Figure 3D, even in stand-by period STB, when the signal CS2B becomes "H" level and the gates of transistors of push-pull circuit PP are pulled to ground potential, the inverted signal AB increases up to a level $L_2$ determined by the threshold level of the depletion type transistor $T_8$ as in the case of Figure 3C, but the signal A maintains a level $L_3$ which is almost equal to $V_{cc}$, as illustrated in Figure 3E, since charges at terminal $N_1$ are held because the transistor $T_{12}$ is in the OFF state and there is no discharge route.

This level $L_3$ is gradually reduced as a result of junction leakage etc., but such variation cannot be expected to have any significant effect in a case in which a transistor operates over a short cycle.

In the next active period ACT, change of output level starts from $L_2$ and $L_3$ and the inverted signal AB increases to power source voltage $V_{cc}$ from level $L_2$, as in the case of Figure 3C, but the signal A decreases to ground potential GND from level $L_3$ (=$V_{cc}$). Thereby a time difference $T_0$ is manifest between changes of output in the cases of Figure 3C and Figure 3E.

The input stage of an address decoder (not illustrated) comprises a NOR gate which receives a plurality of in-phase and inverted-phase address signals as inputs thereto and its speed of operation is determined by the changes of inputs thereto between "H" and "L" levels. Therefore, when selecting in row or column directions, a time difference corresponding to $T_0$ is generated in the course of operations as indicated in Figures 3. This time difference $T_0$ is generally very small and does not give rise to a problem, as mentioned above, when chip select access is faster than address access. However, if chip select access is slower than address access as a result of circuit design, access to memory is delayed by the time difference $T_0$ explained above.

In the present invention, with a view to removing such disadvantages, short circuit means, consisting of an enhancement type MOS transistor $T_{16}$, is connected as shown in Figure 1 between the complementary output terminals $N_1$, $N_2$ of the push-pull stage PP at the output stage of an address buffer circuit. This short circuit means is controlled by the internal chip select signal CS2B which is in-phase with the external chip select signal. For this reason, the transistor $T_{16}$ becomes OFF in an active period ACT and thereby completely isolates the complementary output terminals $N_1$, $N_2$ from one another and has no effect on the outputs A, AB, but becomes ON in a stand-by period STB, electrically connecting the terminals $N_1$ and $N_2$.

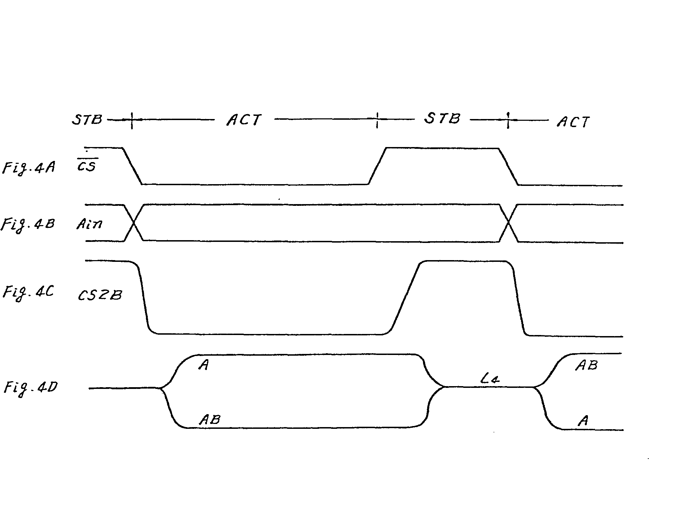

Figures 4A to 4D illustrate operating waveforms of the circuit of Figure 1 where the transistor $T_{16}$ is provided. Figures 4A and 4B correspond to Figures 3A and 3D, Figure 4C illustrates the behaviour of CS2B and Figure 4D illustrates the behaviour of A and AB.

If the transistor $T_{16}$ were not provided, in such circumstances as are illustrated by Figure 4B the outputs A, AB would change as indicated in Figure 3E as mentioned previously, but with the transistor $T_{16}$ in place, which transistor comes ON in a stand-by period STB, the terminals $N_1$ and $N_2$ are electrically connected and the signals A, AB are pulled to the same intermediate level $L_4$.

With reference to voltage drop across transistor $T_{16}$, this transistor becomes completely ON when the gate voltage $V_G$ of this transistor (here, CS2B=$V_{cc}$) is sufficiently higher than the drain voltage $V_D$ (here, the potential A at the point $N_1$), with the result that any voltage drop is not as high as $V_{th}$ ($T_{16}$ threshold voltage).

This condition is not initially satisfied since $V_G$ is equal to $V_D$ initially when the transistor $T_{16}$ becomes ON, but since $V_G$ rises higher than $V_D$ as charges discharge from the point $N_1$ to point $N_2$ when A is "H" and AB is "L" level, the points $N_1$ and $N_2$ are finally connected through the transistor $T_{16}$ without any voltage drop as high as $V_{th}$. Therefore, the levels of A and AB achieve the same intermediate level $L_4$ in stand-by period STB. Since this level $L_4$ is almost equal to the level $L_2$ indicated in Figure 3C and 3E, the levels of A and AB change as shown in Figure 3C when they shift to a next active period ACT. That is, a time difference corresponding to $T_0$ as shown in Figure 3E is not generated.

As explained previously, according to an embodiment of the present invention, since a high speed change of output of a power-down type address buffer circuit can be realized by means of a simple structure, problems concerning delay in access time for a memory device for example can be much improved.

Thus, an address buffer circuit embodying this invention provides a pair of complementary signals, for example for selecting a memory cell of a memory device, according to an address input signal supplied to the buffer circuit. The address buffer circuit comprises short circuit means connected between the two output terminals from which the complementary signals are respectively provided. During a stand-by period of the memory device the short circuit means electrically connects the two output terminals so that the potentials of the two terminals achieve a common level intermediate between high and low levels provided at the output terminals during an active period of the memory device.

## Claims

1. An address buffer circuit, operable to receive an externally provided address input ($A_{in}$), said circuit comprises

a first push-pull output circuit having a first depletion MOS transistor (T7) and a first enhancement MOS transistor (T12) connected to the first depletion MOS transistor (T7), respective gates of which first transistors are arranged for receiving respective address input signals which are mutually complementary, and

a second push-pull output circuit having a second depletion MOS transistor (T8) and a second enhancement MOS transistor (T13) connected to the second depletion MOS transistor (T8), respective gates of which second transistors are arranged for receiving respective said address input signals,

said first and second push-pull output circuits being operable in an active period to provide, at respective output terminals ($N_1$, A; $N_2$, AB) thereof, a pair of mutually complementary output signals of levels dependent upon the address input signals; and further comprises

power down MOS transistors (T14, T15) operable in a stand-by period, designated by a signal ($\overline{CS}$ fig. 2) provided externally of the buffer circuit, to pull down the gate levels of the first and second depletion and enhancement MOS transistors (T7, T8, T12, T13) in order to reduce power consumption by the buffer circuit,

characterised in that a short circuit means (T16) is connected between the respective output terminals ($N_1$, A; $N_2$, AB), which means is operable to set the potentials of the output terminals in a stand-by period to a level between high and low levels of the output terminals in an active period, by electrically connecting the output terminals.

2. An address buffer circuit as claimed in claim 1 wherein the externally provided signal is a chip select signal ($\overline{CS}$).

3. An address buffer circuit as claimed in claim 1 or 2, wherein the short circuit means comprises a MOS transistor (T16).

4. An address buffer circuit as claimed in claim 3 when read as appended to claim 2, wherein the MOS transistor is controlled in dependence upon the chip select signal ($\overline{CS}$).

5. An address buffer circuit as claimed in any preceding claim, connected in circuitry for addressing a memory device.

6. An address buffer circuit as claimed in any preceding claim, further comprising three invertor stages ($I_1$, $I_2$, $I_3$) connected for effecting successive inversions of the externally provided address input ($A_{in}$), each invertor stage having a depletion type MOS transistor ($T_4$, $T_5$, $T_6$) and an enhancement type MOS transistor ($T_9$, $T_{10}$, $T_{11}$), to provide said address input signals as outputs of the second ($I_2$) and third ($I_3$) invertor stages, and additional power-down MOS transistors ($T_1$, $T_2$, $T_3$), operable in the standby period to turn OFF to disconnect the invertor stages from power supply.

7. An address buffer circuit as claimed in claim 6, further comprising circuitry (fig. 2) operable to generate from the externally provided signal ($\overline{CS}$) first (CS2B) and second (CSO) internal signals for application respectively to gates of the additional power-down MOS transistors ($T_1$, $T_2$, $T_3$) and gates of the power-down MOS transistors ($T_{14}$, $T_{15}$) of claim 1, having depletion type load MOS transistors ($T_{17}$ to $T_{20}$) and enhancement type drive MOS transistors ($T_{21}$ to $T_{24}$) arranged to provide two invertor stages ($I_4$, $I_5$), operable to effect successive inversions of the externally provided signal ($\overline{CS}$) to generate the first internal signal (CS2B), and three invertor stages ($I_4$, $I_6$, $I_7$), operable to effect successive inversions of the externally provided signal ($\overline{CS}$) to generate the second internal signal (CSO).

## Patentansprüche

1. Adressenpufferschaltung, die einen extern gelieferten Adresseneingang ($A_{in}$) empfangen kann, mit

einer ersten Gegentakt-Ausgangsschaltung, welche einen ersten MOS-Transistor (T7) vom Verarmungstyp und einen ersten MOS-Transistor (T12) vom Anreicherungstyp hat, welcher mit dem ersten Verarmungstyp-MOS-Transistor (T7) verbunden ist, wobei entsprechende Gates dieser ersten Transistoren zum Empfang der jeweiligen Adresseneingangssignale angeordnet sind, welche wechselseitig komplementär sind, und

einer zweiten Gegentakt-Ausgangsschaltung, welche einen zweiten Verarmungs-MOS-Transistor (T8) und einen zweiten Anreicherungs-MOS-Transistor (T13) umfaßt, welcher mit dem zweiten Verarmungs-MOS-Transistor (T8) verbunden ist, wobei entsprechende Gates dieser zweiten Transistoren zum Empfang der jeweiligen genannten Adresseneingangssignal angeschlossen sind,

wobei die erste und die zweite Gegentakt-Ausgangsschaltung während einer aktiven Periode tätig sind, um an ihre jeweiligen Ausgangsanschlüsse ($N_1$, A; $N_2$, AB) ein Paar von wechselseitig komplementären Ausgangssignalen mit Pegeln zu liefern, die von den Adresseneingangssignalen abhängen; und ferner mit Abschalt-MOS-Transistoren (T14, T15), die in einer Bereitschafts-periode, welche durch ein Signal ($\overline{CS}$, Figur 2), das außerhalb der Pufferschaltung erzeugt wird, bezeichnet ist tätig werden, um die Gatepegel der ersten und zweiten Verarmungs- und Anreicherungs-MOS-Transistoren (T7, T8, T12, T13) herabzuziehen, um den Leistungsverbrauch der Pufferschaltung zu reduzieren,

dadurch gekennzeichnet, daß eine Kurzschlußeinrichtung (T16), zwischen den jeweiligen Ausgangsanschlüsse ($N_1$, A; $N_2$, AB) angeschlossen ist, die betreibbar ist, um die Potentiale der Ausgangsanschlüsse während einer Bereitschaftsperiode, durch elektrische Verbindung der Ausgangsanschlüsse, auf einem Pegel zwischen den hohen und den niedrigen Pegeln der Ausgangsanschlüsse in einer aktiven Periode zu setzen.

2. Adressenpufferschaltung nach Anspruch 1, bei welcher das extern erzeugte Signal ein Chipauswahlsignal ($\overline{CS}$) ist.

3. Adressenpufferschaltung nach Anspruch 1 oder 2, bei welcher die Kurzschlußeinrichtung einen MOS-Transistor (T16) umfaßt.

4. Adressenpufferschaltung nach Anspruch 3 in Verbindung mit Anspruch 2, bei welcher der MOS-Transistor in Abhängigkeit von dem Chipauswahlsignal ($\overline{CS}$) gesteuert ist.

5. Adressenpufferschaltung nach einem der vorhergehenden Ansprüche, angeschlossen in einer Schaltung zur Adressierung einer Speichervorrichtung.

6. Adressenpufferschaltung nach einem der vorhergehenden Ansprüche, ferner gekennzeichnet durch drei Inverterstufen ($I_1$, $I_2$, $I_3$), die zur Bewirkung aufeinanderfolgender Umkehrungen des extern erzeugten Adresseneingangs ($A_{in}$) angeschlossen sind, von denen jede Inverterstufe einen MOS-Transistor ($T_4$, $T_5$, $T_6$) vom Verarmungstyp und einen MOS-Transistor ($T_9$, $T_{10}$, $T_{11}$) vom Anreicherungstyp umfaßt, um die genannten Adresseneingangssignale als Ausgänge der zweiten ($I_2$) un der dritten ($I_3$) Inverterstufen zu liefern, und daß zusätzliche Abschalt-MOS-Transistoren ($T_1$, $T_2$, $T_3$) vorgesehen sind, die während einer Bereitschaftsperiode betrieben werden, um die Inverterstufen von der Stromversorgung abzuschalten oder zu trennen.

7. Adressenpufferschaltung nach Anspruch 6, ferner mit einer Schaltung (Figur 2), die betrieben werden kann, um aus dem extern gelieferten Signal ($\overline{CS}$) erste (CS2B) und zweite (CSO) interne Signale zur Anwendung auf die jeweiligen Gates der zusätzlichen Abschalt-MOS-Transistoren ($T_1$, $T_2$, $T_3$) und auf die Gates der Abschalt-MOS-Transistoren ($T_{14}$, $T_{15}$), von Anspruch 1, zu erzeugen, und die Last-MOS-Transistoren ($T_{17}$ bis $T_{20}$) vom Verarmungstyp und Treiber-MOS-Transistoren ($T_{21}$ bis $T_{24}$) vom Anreicherungstype umfaßt, welche so angeordnet sind, daß sie die beiden Inverterstufen ($I_4$, $I_5$) bilden, welche aufeinanderfolgende Umkehrungen des extern gelieferten Signals ($\overline{CS}$) bewirken, um das erste interne Signal (CS2B) zu erzeugen, und

drei Invertstufen ($I_4$, $I_6$, $I_7$) umfaßt, die aufeinanderfolgende Umkehrungen des extern gelieferten Signals ($\overline{CS}$) bewirken, um das zweite intern Signal (CSO) zu erzeugen.

## Revendications

1. Circuit tampon d'adresses pouvant fonctionner pour recevoir un signal d'adresse fourni de l'extérieur ($A_{in}$), ce circuit comprenant:

un premier circuit de sortie push-pull comportant un premier transistor à métal-oxyde-semiconducteur (MOS) à appauvrissement (T7) et un premier transistor MOS à enrichissement (T12) connecté au premier transistor MOS à appauvrissement (T7), les grilles respectives des premiers transistors étant agencées pour recevoir des signaux d'entrée d'adresse respectifs qui sont complémentaires entre eux, et

un second circuit de sortie push-pull comportant un second transistor MOS à appauvrissement (T8) et un second transistor MOS à enrichissement (T13) connecté au second transistor MOS à appauvrissement (T8), les grilles respectives des seconds transistors étant agencées pour recevoir les signaux d'entrée d'adresse respectifs,

les premier et second circuits de sortie push-pull pouvant fonctionner pendant une période active pour fournir, à leurs bornes de sortie respectives ($N_1$, A; $N_2$, AB), deux signaux de sortie complémentaires entre eux de niveaux dépendant des signaux d'entrée d'adresse; et comprenant en outre

des transistors MOS de coupure d'alimentation (T14, T15) pouvant fonctionner pendant une période de repos, sensibles à un signal ($\overline{CS}$, Figure 2) fourni de l'extérieur du circuit tampon, pour faire chuter les niveaux de grille des premiers et seconds transistors MOS à appauvrissement et à enrichissement (T7, T8, T12, T13) afin de réduire la consommation d'énergie du circuit tampon,

caractérisé en ce qu'un moyen d'établissement de court-circuit (T16) est connecté entre les bornes de sortie respectives ($N_1$, A; $N_2$, AB), ce moyen pouvant fonctionner pour régler les tensions des bornes de sortie pendant une période de repos à un niveau compris entre le niveau haut et le niveau bas des bornes de sortie pendant une période active, en connectant électriquement les bornes de sortie.

2. Circuit tampon d'adresses selon la revendication 1, caractérisé en ce que le signal fourni de l'extérieur est un signal de sélection de pastille ($\overline{CS}$).

3. Circuit tampon d'adresses selon l'une quelconque des revendications 1 et 2, caractérisé en ce que le moyen d'établissement de court-circuit comprend un transistor MOS (T16).

4. Circuit tampon d'adresses selon la revendication 3, caractérisé en ce que le transistor MOS est commandé en fonction du signal de sélection de pastille ($\overline{CS}$).

5. Circuit tampon d'adresses selon l'une quelconque des revendications 1 à 4, caractérisé en ce qu'il est connecté dans un circuit d'adressage d'une mémoire.

6. Circuit tampon d'adresses selon l'une quelconque des revendications 1 à 5, caractérisé en ce qu'il comprend en outre trois étages inverseurs ($I_1$, $I_2$, $I_3$) connectés pour exécuter des inversions successives du signal d'entrée d'adresse fourni de l'extérieur ($A_E$), chaque étage inverseur comportant un transistor MOS du type à appauvrissement ($T_4$, $T_5$, $T_6$) et un transistor MOS du type à enrichissement ($T_9$, $T_{10}$, $T_{11}$), pour fournir les signaux d'entrée d'adresse comme signaux de sortie des second ($I_2$) et troisième ($I_3$) étages inverseurs, et des transistors MOS de coupure d'alimentation supplémentaires ($T_1$, $T_2$, $T_3$) pouvant fonctionner pendant la période de repos pour devenir bloqués afin de déconnecter les étages inverseurs de l'alimentation.

7. Circuit tampon d'adresses selon la revendication 6, caractérisé en ce qu'il comprend en outre un circuit (Figure 2) pouvant fonctionner pour engendrer à partir du signal fourni de l'extérieur ($\overline{CS}$) un premier (CS2B) et un second (CSO) signaux intérieurs pour leur application respectivement aux grilles des transistors MOS de coupure d'alimentation supplémentaires ($T_1$, $T_2$, $T_3$) et aux grilles dey transistors MOS de coupure d'alimentation ($T_{14}$, $T_{15}$) de la revendication 1, comportant des transistors MOS de charge du type à appauvrissement ($T_{17}$ à $T_{20}$) et des transistors MOS de commande du type à enrichissement ($T_{21}$ à $T_{24}$) agencés pour fournir deux étages inverseurs ($I_4$, $I_5$), pouvant fonctionner pour exécuter des inversions successives du signal fourni de l'extérieur ($\overline{CS}$) afin de engendrer le premier signal intérieur (CS2B), et trois étages inverseurs ($I_4$, $I_6$, $I_7$), pouvant fonctionner pour exécuter des inversions successives du signal fourni de l'extérieur ($\overline{CS}$) afin d'engendrer le second signal intérieur (CSO).

Fig. 1

Fig. 2

STB —— ┼—— ACT —————— ┼—— STB ——┼— ACT

Fig.3A  $\overline{CS}$

Fig.3B  Ain

Fig.3C
A
AB
L2
L1
AB
A

Fig.3D  Ain

Fig.3E
A
AB
L3
L2
AB
A

$T_0$

STB ——|—— ACT ———————|—— STB ——|—— ACT

Fig.4A  $\overline{CS}$

Fig.4B  Ain

Fig.4C  CS2B

Fig.4D

A

AB

L4

AB

A